(19) Europäisches Patentamt
European Patent Office
Office européen des brevets

(11) EP 3 635 428 B1

(12) **FASCICULE DE BREVET EUROPEEN**

(45) Date de publication et mention de la délivrance du brevet:
**17.03.2021 Bulletin 2021/11**

(21) Numéro de dépôt: **18726492.4**

(22) Date de dépôt: **30.05.2018**

(51) Int Cl.:
***G01S 3/30*** *(2006.01)* ***G01S 3/36*** *(2006.01)*

(86) Numéro de dépôt international:
**PCT/EP2018/064167**

(87) Numéro de publication internationale:
**WO 2018/224371 (13.12.2018 Gazette 2018/50)**

(54) **PROCÉDÉ ET DISPOSITIF D'ESTIMATION D'UN ANGLE D'ARRIVÉE D'UN SIGNAL RADIOÉLECTRIQUE INCIDENT**

VERFAHREN UND VORRICHTUNG ZUR SCHÄTZUNG DES ANKUNFTSWINKELS EINES EINFALLENDEN FUNKSIGNALS

METHOD AND DEVICE FOR ESTIMATING AN ANGLE OF ARRIVAL OF AN INCIDENT RADIO SIGNAL

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **09.06.2017 FR 1700615**

(43) Date de publication de la demande:
**15.04.2020 Bulletin 2020/16**

(73) Titulaire: **Thales**
**92400 Courbevoie (FR)**

(72) Inventeurs:
- **GORISSE, Benoît**
  **29200 Brest (FR)**
- **JAHAN, Daniel**
  **29200 Brest (FR)**
- **CORNU, Cédric**
  **29200 Brest (FR)**

(74) Mandataire: **Lavoix**
**2, place d'Estienne d'Orves**
**75441 Paris Cedex 09 (FR)**

(56) Documents cités:
**WO-A1-2007/028278 FR-A1- 3 041 762**
**US-A1- 2014 159 954**

- **JONI POLILI LIE ET AL: "Single antenna power measurements based direction finding with incomplete spatial coverage", 2012 IEEE INTERNATIONAL CONFERENCE ON ACOUSTICS, SPEECH AND SIGNAL PROCESSING (ICASSP 2012) : KYOTO, JAPAN, 25 - 30 MARCH 2012 ; [PROCEEDINGS], IEEE, PISCATAWAY, NJ, 25 mars 2012 (2012-03-25), pages 2641-2644, XP032227697, DOI: 10.1109/ICASSP.2012.6288459 ISBN: 978-1-4673-0045-2**

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

EP 3 635 428 B1

## Description

La présente invention concerne un procédé d'estimation d'un angle d'arrivée d'un signal radioélectrique incident par rapport à une direction de référence prédéterminée, en utilisant un ensemble de N voies de réception comportant des antennes directives pointant selon des directions de réception différentes et un dispositif d'estimation d'angle d'arrivée d'un signal radioélectrique incident associé.

L'invention se situe dans le domaine de la goniométrie d'amplitude, et trouve une application particulière dans la détection de signaux radioélectriques émis par des radars.

Le procédé de l'invention s'applique notamment pour la goniométrie à une dimension, pour l'estimation d'un angle d'arrivée d'un signal radioélectrique incident dans un plan, en utilisant la puissance mesurée par un ensemble de voies de réception comprenant chacune une antenne directive de réception.

Le principe appliqué est l'estimation d'un angle d'arrivée, définissant une direction d'arrivée, d'un signal radioélectrique à partir d'un nombre N de puissances $x_0, x_1, ...., x_{N-1}$ des signaux délivrés par N voies de réception à antennes directives respectivement pointées dans des directions choisies du plan de détection, correspondant à des angles $\theta_0, \theta_1, ...., \theta_{N-1}$ par rapport à une direction de référence prédéterminée. Le nombre N est a priori quelconque, en pratique N est en général compris entre 4 et 16.

Cependant, dans certains cas de figure, la puissance rayonnée par un signal radioélectrique incident est faible, et même en utilisant dans la chaîne de réception des amplificateurs entre la sortie de chaque antenne et la mesure de puissance, il est possible que seules L voies de réception à antennes adjacentes, formant un sous-ensemble parmi les N voies de réception, délivrent une puissance supérieure ou égale au seuil de détection appliqué.

En effet, lorsque la puissance rayonnée est faible, seules les voies de réception dont les antennes ont une direction proche de la direction incidente reçoivent une puissance supérieure au seuil de détection, les autres puissances étant inférieures à ce seuil, ne seront pas mesurées. Dans ce cas, les algorithmes classiques d'estimation de l'angle d'arrivée sont mis en défaut.

Les documents « Single antenna power measurements based direction finding with incomplète spatial coverage » de Lie et al, ICASSP 2012 ; WO2007/028278 A1 et US2014/159954 A1 traitent de l'estimation de la direction d'un signal incident dans des cas de couverture spatiale incomplète.

Un problème analogue se pose avec l'emploi de mesureurs numériques à sous-échantillonnage dans un goniomètre d'amplitude. En effet, de tels mesureurs utilisent le sous-échantillonnage pour diminuer le débit et réaliser une analyse spectrale de signaux très large bande instantanée, de l'ordre de plusieurs GHz à plusieurs dizaines de GHz, mais cela entraîne des repliements de spectre dans la bande d'analyse spectrale. Par conséquent, la fréquence mesurée est ambiguë et pour lever les ambiguïtés, plusieurs voies numériques ayant des fréquences différentes, comportant chacune une conversion analogique-numérique et une analyse spectrale, sont disposées en parallèle. Le nombre de signaux présents en parallèle peut alors dépasser la limite prévue. Une conséquence est une absence de mesure de puissance sur certaines voies de réception et certains signaux.

L'invention a pour objet de remédier aux inconvénients précités.

A cet effet, l'invention propose un procédé d'estimation d'un angle d'arrivée d'un signal radioélectrique incident par rapport à une direction de référence prédéterminée, en utilisant un ensemble de N voies de réception comportant au moins une antenne directive pointant selon N directions de réception différentes, seul un sous-ensemble d'au moins deux voies de réception à directions d'antennes adjacentes dudit ensemble d'antennes délivrant une puissance mesurée en réception dudit signal radioélectrique incident. Le procédé comprend étapes de :

- détermination d'un nombre de voies de réception délivrant une puissance mesurée formant ledit sous-ensemble, et d'un indice de référence correspondant à une première voie de réception dans un sens de parcours de l'ensemble de directions d'antennes dudit sous-ensemble,
- sélection des puissances mesurées et obtention d'une valeur à attribuer aux puissances non mesurées pour former un signal de puissance complété à N échantillons,
- calcul par application d'une transformation de Fourier discrète audit signal de puissance complété d'au moins une valeur transformée parmi les valeurs transformées correspondant à une première, deuxième et troisième raies de fréquence de la transformation de Fourier discrète, la première raie de fréquence correspondant à la fréquence zéro,
- application d'un estimateur de l'angle d'arrivée utilisant la ou les valeurs transformées calculées, ledit estimateur étant dépendant dudit indice de référence.

Avantageusement, le procédé de l'invention permet d'améliorer la précision d'estimation d'angle d'arrivée dans le cas où seul un sous-ensemble d'au moins deux voies de réception fournit des puissances mesurées, en utilisant des valeurs attribuées aux puissances non mesurées qui sont optimisées en lien avec l'estimateur d'angle d'arrivée appliqué.

Le procédé d'estimation d'un angle d'arrivée d'un signal radioélectrique selon l'invention peut également présenter une ou plusieurs des caractéristiques ci-dessous, prises indépendamment ou en combinaison.

La valeur à attribuer aux puissances non mesurées est une valeur non nulle, dépendant des indices des voies de réception dudit sous-ensemble et des puissances mesurées correspondantes.

La valeur à attribuer aux puissances non mesurées dépend en outre d'une fréquence mesurée du signal radioélectrique.

La valeur à attribuer aux puissances non mesurées est sensiblement égale à une valeur moyenne de N puissances obtenues à partir d'au moins un diagramme de rayonnement correspondant à la puissance mesurée par une antenne de voie de réception.

Une pluralité de valeurs à attribuer aux puissances non mesurées est préalablement obtenue par calcul ou par expérimentation, lesdites valeurs étant mémorisées dans une table.

A l'étape de calcul est effectué le calcul de la valeur transformée correspondant à la deuxième raie de fréquence de la transformation de Fourier discrète, ladite valeur transformée étant un nombre complexe défini par un module et un argument.

L'estimateur est un premier estimateur, l'application dudit premier estimateur comprenant le calcul de l'argument de la valeur transformée calculée et la soustraction dudit argument à une valeur d'angle de référence.

L'application d'un estimateur met en oeuvre au moins une valeur de coefficient transformé obtenu par application de la transformation de Fourier à un ensemble de coefficients représentatif du sous-ensemble de directions d'antennes fournissant une puissance mesurée, ladite valeur de coefficient transformé dépendant de l'indice de référence et du nombre de voies de réception dudit sous-ensemble.

A l'étape de calcul est effectué en outre le calcul de la valeur transformée correspondant à la première raie de fréquence de la transformation de Fourier discrète, et ledit estimateur est un deuxième estimateur, l'application dudit deuxième estimateur comprenant le calcul de l'argument d'un terme dépendant des valeurs transformées correspondant à la première et à la deuxième raies de fréquence, de ladite valeur à attribuer aux puissances non mesurées et de valeurs de coefficients transformés.

L'étape de calcul est effectué en outre le calcul des valeurs transformées correspondant respectivement à la première et à la troisième raies de fréquence de la transformation de Fourier discrète, et l'estimateur est un troisième estimateur, l'application dudit troisième estimateur comprenant le calcul de l'argument d'un terme dépendant des valeurs transformées correspondant aux première, deuxième et troisième raies de fréquence, de ladite valeur attribuée aux puissances non mesurées et de valeurs de coefficients transformés.

La valeur à attribuer aux puissances non mesurées est égale à zéro, et l'application d'un estimateur met en œuvre au moins une valeur de coefficient transformé obtenu par application de la transformation de Fourier à un ensemble de coefficients représentatif du sous-ensemble de directions d'antennes fournissant une puissance mesurée, ladite valeur de coefficient transformé dépendant de l'indice de référence et du nombre de voies de réception dudit sous-ensemble.

A l'étape de calcul est effectué en outre le calcul des valeurs transformées correspondant respectivement à la deuxième et à la troisième raies de fréquence de la transformation de Fourier discrète, et ledit estimateur est un quatrième estimateur, l'application dudit quatrième estimateur comprenant le calcul de l'argument d'un terme dépendant des valeurs transformées correspondant aux deuxième et troisième raies de fréquence et de valeurs de coefficients transformés.

Selon un autre aspect, l'invention concerne un dispositif d'estimation d'un angle d'arrivée d'un signal radioélectrique incident par rapport à une direction de référence prédéterminée, en utilisant un ensemble de N voies de réception comportant au moins une antenne directive pointant selon N directions de réception différentes, seul un sous-ensemble d'au moins deux voies de réception à directions d'antennes adjacentes dudit ensemble d'antennes délivrant une puissance mesurée en réception dudit signal radioélectrique incident. Le dispositif comprend des modules adaptés à :

- déterminer un nombre de voies de réception délivrant une puissance mesurée formant ledit sous-ensemble, et un indice de référence correspondant à une première voie de réception dans un sens de parcours de l'ensemble de directions d'antennes dudit sous-ensemble,
- sélectionner des puissances mesurées et obtenir une valeur à attribuer aux puissances non mesurées pour former un signal de puissance complété à N échantillons,
- calculer par application d'une transformation de Fourier discrète audit signal de puissance complété au moins une valeur transformée parmi les valeurs transformées correspondant à une première, deuxième et troisième raies de fréquence de la transformation de Fourier discrète, la première raie de fréquence correspondant à la fréquence zéro,
- appliquer un estimateur de l'angle d'arrivée utilisant la ou les valeurs transformées calculées, ledit estimateur étant dépendant dudit indice de référence.

Dans un mode de réalisation, on utilise un ensemble de N voies de réception comportant chacune une antenne directive pointant une direction de réception différente, dont seul un sous-ensemble d'au moins deux voies de réception à directions d'antennes adjacentes dudit ensemble d'antennes délivre une puissance mesurée en réception dudit signal radioélectrique incident.

D'autres caractéristiques et avantages de l'invention ressortiront de la description qui en est donnée ci-dessous, à titre indicatif et nullement limitatif, en référence aux figures annexées, parmi lesquelles :

- la figure 1 illustre schématiquement un système de goniométrie à N=6 antennes dans un plan dans lequel est défini un angle d'arrivée $\theta$ d'un signal radioélectrique;
- la figure 2 est un schéma synoptique d'un dispositif d'estimation d'angle d'arrivée général ;
- la figure 3 est un schéma synoptique d'un dispositif d'estimation d'angle d'arrivée mettant en œuvre un procédé d'estimation d'angle d'arrivée selon un premier mode de réalisation ;
- la figure 4 est un schéma synoptique d'un dispositif d'estimation d'angle d'arrivée mettant en œuvre un procédé d'estimation d'angle d'arrivée selon un deuxième mode de réalisation ;
- la figure 5 est un schéma synoptique d'un dispositif d'estimation d'angle d'arrivée mettant en œuvre un procédé d'estimation d'angle d'arrivée selon un troisième mode de réalisation ;
- la figure 6 est un schéma synoptique d'un dispositif d'estimation d'angle d'arrivée mettant en œuvre un procédé d'estimation d'angle d'arrivée selon un quatrième mode de réalisation.

La figure 1 illustre schématiquement dans un plan un système de goniométrie à N=6 antennes directives, notées $A_0$ à $A_5$, chacune ayant une direction de pointage associée et faisant partie d'une voie de réception comme expliqué ci-dessous. Chaque direction de pointage est respectivement caractérisée par un angle associé $\theta_0$ à $\theta_5$, défini par rapport à une direction de référence prédéterminée. Dans l'exemple, la direction de référence prédéterminée est la direction de l'axe X du repère (X,Y) du plan.

De manière plus générale, un nombre N quelconque d'antennes $A_0,...A_n, ..., A_{N-1}$ est considéré.

Les directions de pointage des antennes sont régulièrement réparties angulairement sur $\Omega$=360°, l'exemple de la figure 1 montre 6 antennes pointées tous les 60°. En pratique, la répartition angulaire présente une tolérance, par exemple de quelques degrés.

Des directions de pointages des antennes irrégulières ne se prêtent pas à l'emploi de la Transformée de Fourier Discrète tel que décrit ci-après. Une adaptation spécifique est néanmoins envisageable.

En particulier, on considère le cas d'une répartition légèrement irrégulière sur 360°: les N directions de pointage des N antennes correspondent aux N directions régulières tous les 360°/N à un décalage près, variable d'une antenne à l'autre, mais n'excédant pas $\pm$10% de 360°/N. Dans ce cas, l'erreur engendrée est faible et est corrigée de manière calculatoire.

Dans un autre cas particulier, on considère une répartition incomplète sur 360°, par exemple 4 antennes se succédant à 45° d'intervalle. Le signal radioélectrique incident S de l'exemple schématique de la figure 1 arrive avec un angle d'arrivée $\theta$ par rapport à la direction de référence prédéterminée.

Les antennes $A_0$ à $A_5$ sont des antennes directives ayant de préférence les mêmes caractéristiques de fonctionnement.

Chacune des antennes $A_n$ reçoit une puissance rayonnée PR. Comme illustré à la figure 2, chaque antenne $A_n$ est branchée en entrée d'un module de mesure de puissance $10_n$ comportant une chaîne de réception $12_n$ pouvant comporter notamment des amplificateurs. La chaîne de réception $12_n$ est suivie d'un module de mesure de puissance $14_n$, fournissant en sortie une puissance mesurée $x_n$ lorsque cette puissance est supérieure à un seuil de détection prédéterminé.

L'ensemble formé par une antenne $A_n$ et le module de mesure de puissance $10_n$ correspondant forme une voie de réception, qui délivre ou non une puissance mesurée.

Le seuil de détection est lié à la puissance de bruit en fin de chaîne de réception et est choisi, de manière classique, pour la qualité de la détection avec des probabilités de fausse alarme et de détection ou pour la précision des mesures à réaliser, par exemple il est souvent compris entre 16 et 24dB.

Les puissances mesurées $x_0,x_1,....,x_{N-1}$ sont fournies à un module 20 d'estimation de la direction d'arrivée, mettant en œuvre les divers modes de réalisation du procédé de l'invention.

L'invention s'applique en particulier dans le cas de figure où seul un sous-ensemble de L voies de réception, avec L>1, comportant des antennes adjacentes parmi les N voies de réception fournit une puissance mesurée, alors que N-L voies de réception ne fournissent pas de puissance mesurée.

Par exemple, dans la figure 1, seules les voies de réception des antennes $A_5$, $A_0$, $A_1$ et $A_2$ fournissent une valeur de puissance mesurée $x_5,x_0,x_1,x_2$, les voies de réception des antennes $A_3$ et $A_4$ ne fournissant pas de puissance mesurée. Dans ce cas, N=6, L=4.

Le module 20 d'estimation de la direction d'arrivée est adapté à calculer une valeur d'angle $\hat{\theta}$ qui est une estimation de la valeur de l'angle d'incidence $\theta$ du signal radioélectrique incident S.

Le module 20 d'estimation de la direction d'arrivée est par exemple mis en œuvre par un dispositif programmable, comportant un ou plusieurs processeurs, aptes à exécuter des instructions de code exécutable lorsque le dispositif programmable est mis sous tension, et un module de stockage de données, en particulier d'instructions de code exécutable. Selon une variante, le dispositif programmable mettant en œuvre le module 20 est réalisé sous forme de carte programmée de type ASIC ou FPGA.

Il est à noter qu'en théorie, lorsque toutes les N antennes de réception $A_n$ fournissent une puissance mesurée, l'angle d'arrivée du signal radioélectrique incident peut être estimé de la manière suivante :

$$\hat{\theta} = Arctg\left(\frac{\sum_{n=0}^{N-1} x_n \cdot \sin\theta_n}{\sum_{n=0}^{N-1} x_n \cdot \cos\theta_n}\right) = Arg\left(\sum_{n=0}^{N-1} x_n \cdot e^{i\theta_n}\right) \text{ (eq 1)}$$

où Arctg() est la fonction trigonométrique arc tangente, et Arg() est l'argument d'un nombre complexe, et $e^{i\theta_n}$ est le nombre complexe d'argument $\theta_n$ et de module 1.

Les antennes de réception ont des directions réparties uniformément sur ce qui s'écrit :

$$\theta_n = \theta_0 + n\frac{2\pi}{N} \text{ (eq 2)}$$

En combinant les équations (eq 1) et (eq 2) on obtient :

$$\hat{\theta} = Arg\left(\sum_{n=0}^{N-1} x_n \cdot e^{i(\theta_0 + n\frac{2\pi}{N})}\right) = \theta_0 + Arg\left(\sum_{n=0}^{N-1} x_n \cdot e^{i\frac{2\pi}{N}}\right) \text{ (eq 3)}$$

La transformation de Fourier discrète du signal $x_0,x_1,....,x_{N-1}$, pour une raie de fréquence d'indice fréquentiel k compris entre 0 et N-1, s'écrit :

$$X_k = \sum_{n=0}^{N-1} x_n \cdot e^{-i\frac{2\pi}{N}kn} \text{ (eq 4)}$$

La transformation de Fourier discrète fournit des valeurs transformées correspondant à N raies de fréquence, la première raie de fréquence correspondant à l'indice fréquentiel 0, la deuxième raie de fréquence à l'indice fréquentiel 1, la troisième raie de fréquence à l'indice fréquentiel 2 et plus généralement la kième raie de fréquence correspond à l'indice fréquentiel k-1.

A partir d'un signal $x_0,x_1,....,x_{N-1}$ on obtient une valeur transformée $X_k$ pour chaque raie de fréquence d'indice $k$.

L'équation (eq 3) s'écrit en fonction de la transformation de Fourier de discrète pour la raie de fréquence d'indice fréquence k=1 :

$$\hat{\theta} = \theta_0 - Arg(X_1) \text{ (eq 5)}$$

L'estimateur théorique de l'angle d'arrivée est donné par la formule (eq 5) ci-dessus. L'angle $\theta_0$ est utilisé comme angle de référence, et c'est l'angle formé par la direction de la première antenne de l'ensemble d'antennes avec la direction de référence.

Cependant, l'invention se situe dans le contexte où le signal $x_0,x_1,....,x_{N-1}$ est parcellaire, seul un sous-ensemble de puissances mesurées étant disponibles.

On note L le nombre d'antennes adjacentes fournissant une puissance mesurée, et P l'indice de la première antenne du sous-ensemble dans un sens de parcours de l'ensemble d'antennes, par exemple le sens des aiguilles d'une montre. L'indice P est appelé indice de référence.

Le sous-ensemble d'antennes fournissant une puissance mesurée est alors formé des antennes d'indices : $I = \{P,(P+1)\text{mod}N,...,(P+L-1)\text{mod}N\}$ où mod désigne l'opérateur modulo.

En reprenant l'exemple ci-dessus en référence à la figure 1, lorsque seules les antennes $A_5$, $A_0$, $A_1$ et $A_2$ fournissent une valeur de puissance mesurée, L=4 et $I = \{5,0,1,2\}$.

La figure 3 illustre schématiquement un dispositif 30 d'estimation d'un angle d'arrivée selon un premier mode de réalisation, mettant en œuvre un premier mode de réalisation du procédé d'estimation d'un angle d'arrivée.

Dans ce premier mode de réalisation de l'invention, une valeur A non nulle est attribuée aux puissances non mesurées.

La valeur A, à attribuer aux puissances non mesurées, est lue dans une table 32, et elle est sensiblement égale à la valeur moyenne de puissance, en unité linéaire, qui aurait été obtenue si les N puissances avaient pu être mesurées sur chaque antenne.

La table 32 des valeurs à attribuer aux puissances non mesurées est construite préalablement et mémorisée, comme expliqué plus en détail ci-après, lors d'une étape préalable de calcul de la table des valeurs à attribuer aux puissances non mesurées, en fonction du diagramme de rayonnement de chaque antenne de l'ensemble d'antennes.

La valeur A à attribuer aux puissances non mesurées est déterminée en fonction des valeurs de puissances mesurées et des indices associés, ainsi que d'une valeur de fréquence estimée $\hat{f}$, de manière à permettre de traiter une large bande de fréquence, typiquement de plusieurs octaves.

La fréquence du signal radioélectrique incident est estimée par un module 34 d'estimation de fréquence, selon les principes et méthodes connus dans l'état de la technique, en fonction du type de récepteurs, numériques ou analogiques, utilisés.

Dans ce premier mode de réalisation de l'invention, le procédé d'estimation d'angle d'arrivée d'un signal radioélectrique incident met en œuvre un module de contrôle 36 qui détermine l'indice P de la première antenne dans le sens de parcours fournissant une puissance mesurée, et le nombre L.

Le module de contrôle 36 commande la sélection, par des sélecteurs $38_i$ des valeurs de puissances correspondantes, $\{x_P, x_{(P+1)\mathrm{mod}N}, \ldots, x_{(P+L-1)\mathrm{mod}N}\}$ pour transmission en entrée d'un module de calcul de transformation de Fourier discrète 40.

Les puissances correspondantes en entrée du module de transformation de Fourier discrète 40 sont notées $\{x'_P, x'_{(P+1)\mathrm{mod}N}, \ldots, x'_{(P+L-1)\mathrm{mod}N}\}$.

Le module de contrôle 36 commande la sélection de la valeur à attribuer aux puissances non mesurées A lue dans la table 32, en fonction, de la valeur de fréquence estimée par le module 34, $\hat{f}$, des indices $P$, ...$(P + L\text{-}1)\mathrm{mod}N$ des puissances mesurées et des puissances mesurées correspondantes.

Les valeurs de puissance non mesurées sont mises à la valeur A :

$$x'_j = A(\hat{f}, P, x_P, (P+1)\bmod N, x_{(P+1)\bmod N}, \ldots, (P+L-1)\bmod N, x_{(p+L-1)\bmod N}) \quad j \notin I \quad \text{(eq 6)}$$

Dans une variante simplifiée, même si le nombre L est supérieur à 2, la valeur A est sélectionnée seulement en fonction des indices $P$ et $(P+1)\mathrm{mod}N$ et des puissances $x_P$ et $x_{(P+1)\mathrm{mod}N}$ correspondantes.

Ainsi, à l'issue des étapes mises en œuvre par le module de contrôle 36, un signal de puissance complété $\{x'_0, x'_1, \ldots, x'_{N-1}\}$ est fourni en entrée du module de calcul de la transformation de Fourier 40.

Le module 40 met en œuvre le calcul d'une valeur transformée correspondant à la raie de fréquence d'indice fréquentiel k=1, selon la formule suivante :

$$X'_1 = \sum_{n=0}^{N-1} x'_n \cdot e^{-i\frac{2\pi}{N}n} \quad \text{(eq 7)}$$

Ensuite le module 42 de mise en œuvre d'un estimateur d'angle d'arrivée met un œuvre le premier estimateur suivant :

$$\hat{\theta} = \theta_0 - Arg X'_1 \quad \text{(eq 8)}$$

Ce premier estimateur fournit un résultat sensiblement équivalent au résultat fourni par l'estimateur théorique applicable lorsque les N voies de réception fournissent des puissances mesurées, en utilisant la valeur transformée $X'_1$ d'indice 1 dans le domaine de Fourier.

La formule (eq 8) du premier estimateur est obtenue comme expliqué ci-dessous.

En effet, si on introduit dans les calculs un coefficient multiplicateur $c_n(P,L)$, représentatif du sous-ensemble d'antennes fournissant une puissance mesurée, égal à 1 pour les indices $n \in I$ pour lesquels les voies de réception à antennes adjacentes fournissant une puissance mesurée, et 0 sinon, le signal de puissance complété peut s'écrire :

$$x_n^{'} = x_n \cdot c_n(P,L) + y_n \cdot (1 - c_n(P,L)) \text{ pour } n \in \{0,...,N-1\} \text{ (eq 9)}$$

Avec $y_n = A$ pour tout indice n.

Dans le domaine de la transformation de Fourier :

$$X_k^{'} = Y_k + (X_k - Y_k) \otimes C_k(P,L) \qquad \text{(eq 10)}$$

Où⊗ désigne l'opération de convolution circulaire, $X_k, Y_k, C_k(P,L)$ sont respectivement les transformées de Fourier discrètes d'indice k des signaux discrets $x_n, y_n, c_n(P,L)$.

Lorsqu'on choisit d'attribuer la valeur A constante aux puissances non mesurées, les valeurs transformées par transformation de Fourier correspondant à $\{y_n = A, 0 \leq n < N\}$ sont :
$Y_0 = N \cdot A$ et $Y_m = 0$ pour $m = 1,2,...,N-1$.

On obtient alors, pour k = 1 :

$$X_1^{'} = (X_0 - Y_0) \cdot C_1 + X_1 \cdot C_0 + X_2 \cdot C_{N-1} + ... + X_{N-2} \cdot C_3 + X_{N-1} \cdot C_2 \qquad \text{(eq 11)}$$

Il est à noter que pour simplifier les notations, on a remplacé les $C_k(P,L)$ par $C_k$ dans la formule ci-dessus.

Les valeurs des coefficients $c_n(P,L)$ étant des valeurs réelles, les valeurs transformées par la transformation de Fourier discrète vérifient la relation :

$$C_{N-k}(P,L) = C_k^*(P,L) \qquad \text{(eq 12)}$$

Où $C_k^*(P,L)$ désigne le conjugué de $C_k(P,L)$, c'est-à-dire le nombre complexe de même module et d'argument de signe opposé.

De plus, les valeurs de puissance $x_n$ sont également des nombres réels, donc une relation analogue s'applique :
$X_{N-k} = X_k^*$.

La formule (eq 11) s'écrit par conséquent, en utilisant les conjugués :

$$X_1^{'} = (X_0 - Y_0) \cdot C_1 + X_1 \cdot C_0 + X_2 \cdot C_1^* + X_3 \cdot C_2^* + ... + X_2^* \cdot C_3 + X_1^* \cdot C_2 \text{ (eq 13)}$$

On appelle ici rang d'un terme comprenant une multiplication de termes élémentaires la somme des indices des termes élémentaires concernés.

En simplifiant les termes de rang supérieur ou égal à 3 dans la formule (eq 13) ci-dessus on obtient :

$$X_1^{'} \approx (X_0 - Y_0) \cdot C_1 + X_1 \cdot C_0 \text{ (eq 14)}$$

La valeur A est sensiblement égale à la moyenne des puissances $x_n$ :

$$A \approx \frac{X_0}{N}$$

Par conséquent, puisque $Y_0 = N \cdot A$, il en résulte : $Y_0 \approx X_0$

La relation (eq 14) se transforme, pour la valeur de A choisie, en :

$$X_1^{'} \approx X_1 \cdot C_0 \text{ (eq 15)}$$

Et $C_0 = L$ qui est réel, par conséquent $Arg(X_1^{'}) \approx Arg(X_1)$

En d'autres termes, grâce au choix de la valeur attribuée aux puissances non mesurées, l'argument de la valeur transformée par transformation de Fourier discrète pour l'indice fréquentiel 1 est sensiblement égal à l'argument de la valeur transformée du signal de puissance complet, qui n'est pas accessible par mesure.

La figure 4 illustre schématiquement un dispositif 50 d'estimation d'un angle d'arrivée selon un deuxième mode de réalisation, mettant en œuvre un deuxième mode de réalisation du procédé d'estimation d'un angle d'arrivée correspondant.

Dans ce deuxième mode de réalisation de l'invention également la même valeur A non nulle est attribuée aux puissances manquantes. Comme dans le premier mode de réalisation, la valeur A est fonction de la valeur de fréquence estimée $\hat{f}$ et des indices $P$ ,..., $(P + L - 1) \bmod N$ et des puissances correspondantes.

Les modules 34 d'estimation de la fréquence du signal radioélectrique incident, de contrôle 36, de sélection $38_n$, ainsi que la table 32 mémorisant des valeurs à attribuer aux puissances manquantes sont similaires aux modules décrits ci-dessus en référence à la figure 4.

En plus de la valeur transformée dans le domaine de Fourier pour l'indice fréquentiel 1, le deuxième estimateur, mis en œuvre par le module d'estimation 46, utilise également la valeur transformée $X_0^{'}$ correspondant à la raie de fréquence d'indice fréquentiel k=0.

La valeur transformée $X_0^{'}$ est calculée par le module d'application de la transformation de Fourier discrète 40 :

$$X'_0 = \sum_{n=0}^{N-1} x'_n \quad \text{(eq 16)}$$

De plus, le deuxième estimateur utilise des valeurs de coefficients transformés $C_k(P,L)$, obtenues par application d'une transformation de Fourier discrète au signal discret formé par les coefficients $c_n(P,L)$.

De préférence, pour optimiser les calculs, les valeurs de coefficients transformés $C_k(P,L)$ sont préalablement calculées et mémorisées dans une table 44.

Le deuxième estimateur appliqué est calculé par la formule suivante :

$$\hat{\theta} = \theta_0 + Arg\left(\frac{(X_0^{'} - N \cdot A) \cdot C_0(P,L) - X_1^{'} \cdot C_1^{*}(P,L)}{C_1(P,L)}\right) \quad \text{(eq 17)}$$

Où A est la valeur à attribuer aux puissances non mesurées lue dans la table 32, les valeurs de coefficients transformés $C_0(P,L)$, $C_1(P,L)$, $C_1^{*}(P,L)$ sont lues dans la table 44.

Il est à noter que $C_0(P,L) = L$.

Le deuxième estimateur est obtenu en utilisant un système d'équations faisant intervenir les valeurs transformées $X_0^{'}$ et $X_1^{'}$, et en négligeant les termes de rang supérieur ou égal à 3.

En effet, en appliquant les formules (eq 10) et (eq 12) on obtient, en remplaçant les $C_k(P,L)$ par $C_k$ pour simplifier les expressions :

$$X_0^{'} - Y_0 = (X_0 - Y_0) \cdot C_0 + X_1 \cdot C_1^{*} + X_2 \cdot C_2^{*} + X_3 \cdot C_3^{*} + ... + X_2^{*} \cdot C_2 + X_1^{*} \cdot C_1 \quad \text{(eq 18)}$$

Ainsi que la formule (eq 13) rappelée ci-dessous :

$$X_1^{'} = (X_0 - Y_0) \cdot C_1 + X_1 \cdot C_0 + X_2 \cdot C_1^{*} + X_3 \cdot C_2^{*} + ... + X_2^{*} \cdot C_3 + X_1^{*} \cdot C_2 \quad \text{(eq 13)}$$

En simplifiant les termes de rang supérieur ou égal à 3 dans ces équations on obtient :

$$X_0^{'} - Y_0 \approx (X_0 - Y_0) \cdot C_0 + X_1 \cdot C_1^* + X_1^* \cdot C_1 \text{ (eq 19)}$$

Ainsi que la simplification de $X_1^{'}$ analogue au premier mode de réalisation :

$$X_1^{'} \approx (X_0 - Y_0) \cdot C_1 + X_1 \cdot C_0 \text{ (eq 14)}$$

Il est possible d'en déduire :

$$X_1^* \approx \frac{(X_0^{'} - Y_0) \cdot C_0 - X_1^{'} \cdot C_1^* - (C_0^2 - |C_1|^2) \cdot (X_0 - Y_0)}{C_0 \cdot C_1} \text{ (eq 20)}$$

Or le choix de la valeur A à attribuer aux puissances non mesurées entraîne $Y_0 = N \cdot A = X_0$, permet de simplifier l'expression de (eq 20) ci-dessus, et de plus $C_0(P,L) = L$ est réel, ce qui permet d'obtenir :

$$Arg(X_1) = -Arg(X_1^*) \approx -Arg\left(\frac{(X_0^{'} - Y_0) \cdot C_0 - X_1^{'} \cdot C_1^*}{C_1}\right) \text{ (eq 21)}$$

Le deuxième estimateur affine le premier estimateur, mais la complexité calculatoire est légèrement augmentée.

La figure 5 illustre schématiquement un dispositif 60 d'estimation d'un angle d'arrivée selon un troisième mode de réalisation, mettant en œuvre un troisième mode de réalisation du procédé d'estimation d'un angle d'arrivée correspondant.

Dans ce troisième mode de réalisation de l'invention également la valeur A non nulle est attribuée aux puissances manquantes.

Les modules 34 d'estimation de la fréquence du signal radioélectrique incident, de contrôle 36, de sélection $38_n$, ainsi que la table 32 mémorisant des valeurs à attribuer aux puissances non mesurées sont analogues aux modules décrits ci-dessus en référence à la figure 4.

En plus des valeurs transformées dans le domaine de Fourier pour les indices fréquentiels 0 et 1, le troisième estimateur, mis en œuvre par le module d'estimation 48, utilise également la valeur transformée $X_2^{'}$ correspondant à la troisième raie de fréquence.

La valeur transformée $X_2^{'}$ est calculée par le module d'application de la transformation de Fourier discrète 40 :

$$X'_2 = \sum_{n=0}^{N-1} x'_n \cdot e^{-i\frac{2\pi}{N}2n} \text{ (eq 22)}$$

Comme dans le mode de réalisation précédent, le troisième estimateur utilise des valeurs de coefficients transformés $C_k(P,L)$, obtenues par application d'une transformation de Fourier discrète au signal discret formé par les coefficients $c_n(P,L)$, préalablement mémorisées dans une table 44.

Le module d'estimation 48 met en œuvre le troisième estimateur, calculé par la formule suivante, dans laquelle les $C_k(P,L)$ ont été remplacés par des $C_k$ pour des raisons de simplification d'écriture :

$$\hat{\theta} = \theta_0 - Arg\left(\frac{(X_0^{'} - N \cdot A) \cdot C_0 \cdot C_2 - X_1^{'} \cdot C_0 \cdot C_1 + X_2^{'} \cdot |C_1|^2}{C_0 \cdot C_1^* \cdot C_2 - C_0^2 \cdot C_1 + C_1 \cdot |C_1|^2}\right) \text{ (eq 23)}$$

Où A est la valeur lue dans la table 32, les coefficients transformés $C_0$, $C_1$, $C_1^*$, $C_2$ sont lus dans la table 44.

Comme noté précédemment, $C_0(P,L) = L$.

Le troisième estimateur est obtenu en utilisant un système d'équations faisant intervenir les valeurs transformées $X'_0$, $X'_1$, $X'_2$ et en négligeant les termes de rang supérieur ou égal à 4.

Le troisième estimateur affine les premier et deuxième estimateurs, mais la complexité calculatoire encore augmentée.

Pour les trois modes de réalisation décrits ci-dessus, la table 32 mémorise des valeurs à attribuer aux puissances non mesurées, en fonction d'une valeur de fréquence estimée, des indices $P,...,(P+L-1)\mathrm{mod}N$ des puissances mesurées et des puissances mesurées $x_P,...,x_{(P+L-1)\mathrm{mod}N}$ correspondantes.

La valeur à attribuer aux puissances non mesurées A est calculée, dans une étape de calcul préalable, à partir d'un diagramme de rayonnement en appliquant la moyenne arithmétique, à partir des valeurs de puissances en unité linéaire, par exemple en milliwatts.

La détermination de chaque valeur A à mémoriser peut se faire par calcul ou par expérimentation.

Les caractéristiques d'antennes évoluent en fonction de la fréquence, donc, lorsqu'on travaille dans une large bande de fréquences, la fréquence estimée permet d'obtenir les courbes correspondant aux diagrammes d'antennes aux différentes fréquences.

Chaque indice $n$ de puissance mesurée correspond à une antenne $A_n$ et à un angle d'orientation $\theta_n$.

Le diagramme de rayonnement à la fréquence mesurée est placé dans un repère puissance-angle d'arrivée de façon à ce que la plage angulaire autour du sommet (gain maximal), pouvant correspondre aux points de puissances mesurées, passe au plus juste par ces points. Ce diagramme de rayonnement, ainsi placé en puissance (ordonnée) et en angle d'arrivée (abscisse), devient le diagramme des puissances délivrées par l'ensemble des antennes. On en déduit les puissances non mesurées comme étant celles de ce diagramme placé, aux angles de pointage des antennes pour lesquelles aucune puissance n'est mesurée.

On a ainsi un jeu complet de puissances, mesurées et déduites, desquelles on va pouvoir tirer la valeur moyenne arithmétique A, les puissances étant exprimées en unité linéaire.

La table A est remplie, dans cette phase de calcul préalable, pour des plages de fréquence, et des plages de valeurs de puissances mesurées.

Avantageusement, grâce à la mémorisation préalable de valeurs attribuables à des puissances non mesurées dans la table dans une phase préalable, la phase effective d'estimation de la direction d'un angle d'arrivée est efficace d'un point de vue calculatoire.

La figure 6 illustre schématiquement un dispositif 70 d'estimation d'un angle d'arrivée selon un quatrième mode de réalisation, mettant en œuvre un quatrième mode de réalisation du procédé d'estimation d'un angle d'arrivée correspondant.

Dans ce quatrième mode de réalisation, le dispositif 70 met en œuvre un module de contrôle 36' des sélecteurs $38'_n$, qui sélectionnent comme puissance $x'_n$ soit la valeur de puissance mesurée $x_n$, soit la valeur zéro si la puissance n'est pas mesurée.

A la différence des trois premiers modes de réalisation, le quatrième mode de réalisation n'utilise pas de valeur de fréquence estimée $\hat{f}$ ni de table 32 de mémorisation de valeurs à attribuer aux puissances non mesurées préalablement calculées.

La table 44 de mémorisation des coefficients transformés $C_k(P,L)$ est utilisée, ainsi que les valeurs transformées $X'_1$ et $X'_2$ obtenues par application de la transformation de Fourier discrète pour la deuxième et troisième raies de fréquence.

Dans ce quatrième mode de réalisation, le module de contrôle 36' détermine l'indice de référence P et les indices $I = \{P,(P+1)\mathrm{mod}N,...,(P+L-1)\mathrm{mod}N\}$ des L antennes adjacentes fournissant une puissance mesurée.

Le module de contrôle 36' commande la sélection, par des sélecteurs $38_n$ des valeurs de puissances correspondantes $\{x_P,x_{(P+1)\mathrm{mod}N},...,x_{(P+L-1)\mathrm{mod}N}\}$ pour transmission en entrée d'un module de calcul de transformation de Fourier discrète 40.

Les puissances correspondantes en entrée du module de transformation de Fourier discrète 40 sont notées $\{x'_P,x'_{(P+1)\mathrm{mod}N},...,x'_{(P+L-1)\mathrm{mod}N}\}$.

Le module de contrôle 36' commande la sélection de la valeur zéro pour les valeurs de puissance non mesurées :

$$x'_j = 0,\ j \notin I \quad \text{(eq 24)}$$

Ainsi, à l'issue des étapes mises en œuvre par le module de contrôle 36', le signal de puissance complété

$\{x'_0, x'_1, ..., x'_{N-1}\}$ est fourni en entrée du module de calcul de la transformation de Fourier 40.

Les valeurs transformées $X_1^{'}$ et $X_2^{'}$ sont calculées.

Le module d'estimation 52 met en œuvre le quatrième estimateur calculé par la formule suivante, avec les notations des coefficients transformés $C_k(P,L)$ simplifiées :

$$\hat{\theta} = \theta_0 - Arg\left(\frac{X_1^{'} \cdot C_2 - X_2^{'} \cdot C_1}{C_0 \cdot C_2 - C_1^2}\right) \text{ (eq 25)}$$

En appliquant les formules (eq 10) et (eq 12) on obtient, en remplaçant les $C_k(P,L)$ par $C_k$ pour simplifier les expressions :

$$X_1^{'} = (X_0 - Y_0) \cdot C_1 + X_1 \cdot C_0 + X_2 \cdot C_1^* + X_3 \cdot C_2^* + ... + X_2^* \cdot C_3 + X_1^* \cdot C_2 \text{ (eq 13)}$$

$$X_2^{'} = (X_0 - Y_0) \cdot C_2 + X_1 \cdot C_1 + X_2 \cdot C_0 + X_3 \cdot C_1^* + ... + X_2^* \cdot C_4 + X_1^* \cdot C_3 \text{ (eq 26)}$$

Le quatrième estimateur est obtenu en utilisant un système d'équations faisant intervenir les valeurs transformées $X_1^{'}$ et $X_2^{'}$, et en négligeant les termes de rang supérieur ou égal à 3, ainsi que le terme $X_2$, ce qui permet d'obtenir :

$$X_1^{'} \approx (X_0 - Y_0) \cdot C_1 + X_1 \cdot C_0 \text{ (eq 14)}$$

$$X_2^{'} \approx (X_0 - Y_0) \cdot C_2 + X_1 \cdot C_1 \text{ (eq 27)}$$

On en déduit :

$$X_1^{'} \approx \frac{X_1^{'} \cdot C_2 - X_2^{'} \cdot C_1}{C_0 \cdot C_2 - C_1^2} \text{ (eq 28)}$$

Le quatrième estimateur est un estimateur alternatif, de coût calculatoire similaire au deuxième estimateur.

Comme déjà expliqué, les divers modes de réalisation de l'invention s'appliquent dès que le nombre L de voies de réception adjacentes délivrant une puissance mesurée est supérieur ou égal à 2.

Dans un cinquième mode de réalisation de l'invention, le procédé comprend une étape de vérification du nombre L de voies de réception délivrant une puissance mesurée.

Si L est supérieur à 1 et inférieur à 4, un des estimateurs parmi les premier, deuxième, troisième ou quatrième estimateurs décrits ci-dessus est appliqué.

Si L est égal à 4, le premier estimateur décrit ci-dessus est appliqué.

Si L est strictement supérieur à 4, la valeur 0 est attribuée aux valeurs manquantes, au lieu de la valeur A, et le premier estimateur selon la formule (eq 8) est appliqué.

Il est à noter que le cas où le sous-ensemble d'antennes fournissant une puissance mesurée est réduit à une seule antenne, c'est-à-dire L=1, n'est pas considéré ici car l'information de puissance reçue est considérée insuffisante pour une estimation fiable de la direction d'arrivée du signal incident.

L'invention a été décrite ici dans un exemple d'application avec une large bande de fréquence, typiquement de plusieurs octaves. Dans certaines applications la bande de fréquence traitée est plus étroite. Dans ce cas, il n'est pas nécessaire d'effectuer une estimation de la fréquence, et les valeurs à attribuer aux fréquences non mesurées ne dépendent pas de la fréquence estimée.

Avantageusement, l'invention permet d'améliorer l'estimation d'un angle d'arrivée d'un signal radioélectrique incident, dans le cas où certaines voies de réception ne fournissent pas de puissance mesurée, tout en disposant d'au moins deux mesures de puissance.

Avantageusement, le calcul préalable et la mémorisation de valeurs utiles pour le calcul des estimateurs permettent d'optimiser le temps de calcul d'un angle d'arrivée estimée.

Avantageusement, l'utilisation d'une valeur à attribuer aux puissances non mesurées sensiblement égale à la valeur moyenne de puissance qui aurait été obtenue si les N puissances avaient pu être mesurées sur chaque antenne permet d'optimiser les estimateurs selon les trois premiers modes de réalisation tout en limitant la place de stockage nécessaire.

L'invention a été décrite ci-dessus dans des systèmes de goniométrie à N antennes directives réparties selon N directions de pointage différentes. En variante, l'invention s'applique de manière analogue dans des systèmes de goniométrie comportant une antenne rotative, adaptée à pointer successivement dans N directions selon un sens de parcours angulaire des directions de pointage donné.

## Revendications

1. Procédé d'estimation d'un angle d'arrivée d'un signal radioélectrique incident par rapport à une direction de référence prédéterminée, en utilisant un ensemble de N voies de réception comportant au moins une antenne directive ($A_0$,...$A_n$, ..., $A_{N-1}$) pointant selon N directions ($\theta_0$,..., $\theta_n$,..., $\theta_{N-1}$) de réception différentes, seul un sous-ensemble d'au moins deux voies de réception à directions d'antennes adjacentes dudit ensemble de voies de réception délivrant une puissance mesurée en réception dudit signal radioélectrique incident (S), comprenant des étapes de :

   - détermination d'un nombre (L) de voies de réception délivrant une puissance mesurée formant ledit sous-ensemble, et d'un indice (P) de référence correspondant à une première voie de réception dans un sens de parcours de l'ensemble de directions d'antennes dudit sous-ensemble,
   - sélection des puissances mesurées ($x_P, x_{(P+1)\mathrm{mod}N},...,x_{(P+L-1)\mathrm{mod}N}$) et obtention d'une valeur (A) à attribuer aux puissances non mesurées pour former un signal de puissance complété ($\{x'_0, x'_1,...,x'_{N-1}\}$) à N échantillons,
   - calcul par application d'une transformation de Fourier discrète audit signal de puissance complété d'au moins une valeur transformée $(X'_0, X'_1, X'_2)$ parmi les valeurs transformées correspondant à une première, deuxième et troisième raies de fréquence de la transformation de Fourier discrète, la première raie de fréquence correspondant à la fréquence zéro,
   - application d'un estimateur ($\hat{\theta}$) de l'angle d'arrivée utilisant la ou les valeurs transformées $(X'_0, X'_1, X'_2)$ calculées, ledit estimateur étant dépendant dudit indice de référence (P).

2. Procédé d'estimation selon la revendication 1, dans lequel ladite valeur (A) à attribuer aux puissances non mesurées est une valeur non nulle, dépendant des indices ($P,(P+1)\mathrm{mod}N,...,(P+L-1)\mathrm{mod}N$) des voies de réception dudit sous-ensemble et des puissances mesurées ($x_P, x_{(P+1)\mathrm{mod}N},...,x_{(P+L-1)\mathrm{mod}N}$) correspondantes.

3. Procédé d'estimation selon la revendication 2, dans lequel ladite valeur (A) à attribuer aux puissances non mesurées dépend en outre d'une fréquence mesurée ($\hat{f}$)du signal radioélectrique.

4. Procédé d'estimation selon la revendication 2 ou 3, dans lequel ladite valeur (A) à attribuer aux puissances non mesurées est sensiblement égale à une valeur moyenne de N puissances obtenues à partir d'au moins un diagramme de rayonnement correspondant à la puissance mesurée par une antenne de voie de réception.

5. Procédé d'estimation selon les revendications 2 à 4, dans lequel une pluralité de valeurs (A) à attribuer aux puissances non mesurées est préalablement obtenue par calcul ou par expérimentation, lesdites valeurs étant mémorisées dans une table (32).

6. Procédé d'estimation selon l'une des revendications 2 à 5, dans lequel à l'étape de calcul est effectué le calcul de la valeur transformée $(X'_1)$ correspondant à la deuxième raie de fréquence de la transformation de Fourier discrète, ladite valeur transformée étant un nombre complexe défini par un module et un argument.

7. Procédé d'estimation selon la revendication 6, dans lequel ledit estimateur est un premier estimateur, l'application dudit premier estimateur comprenant le calcul de l'argument de la valeur transformée calculée et la soustraction dudit argument à une valeur d'angle de référence ($\theta_0$).

**8.** Procédé d'estimation selon la revendication 6, dans lequel l'application d'un estimateur met en œuvre au moins une valeur ($C_k(P,L)$) de coefficient transformé obtenu par application de la transformation de Fourier à un ensemble de coefficients représentatif du sous-ensemble de directions d'antennes fournissant une puissance mesurée, ladite valeur de coefficient transformé dépendant de l'indice de référence (P) et du nombre (L) de voies de réception dudit sous-ensemble.

**9.** Procédé d'estimation selon la revendication 8, dans lequel à l'étape de calcul est effectué en outre le calcul de la valeur transformée $(X'_0)$ correspondant à la première raie de fréquence de la transformation de Fourier discrète, et dans lequel ledit estimateur est un deuxième estimateur, l'application dudit deuxième estimateur comprenant le calcul de l'argument d'un terme dépendant des valeurs transformées correspondant à la première et à la deuxième raies de fréquence, de ladite valeur à attribuer aux puissances non mesurées et de valeurs de coefficients transformés.

**10.** Procédé d'estimation selon la revendication 8, dans lequel à l'étape de calcul est effectué en outre le calcul des valeurs transformées $(X'_0, X'_2)$ correspondant respectivement à la première et à la troisième raies de fréquence de la transformation de Fourier discrète,
et dans lequel ledit estimateur est un troisième estimateur, l'application dudit troisième estimateur comprenant le calcul de l'argument d'un terme dépendant des valeurs transformées $(X'_0, X'_1, X'_2)$ correspondant aux première, deuxième et troisième raies de fréquence, de ladite valeur attribuée aux puissances non mesurées et de valeurs de coefficients transformés.

**11.** Procédé d'estimation selon la revendication 1, dans lequel ladite valeur à attribuer aux puissances non mesurées est égale à zéro, et dans lequel l'application d'un estimateur met en œuvre au moins une valeur de coefficient transformé ($C_k(P,L)$) obtenu par application de la transformation de Fourier à un ensemble de coefficients représentatif du sous-ensemble de directions d'antennes fournissant une puissance mesurée, ladite valeur de coefficient transformé dépendant de l'indice de référence (P) et du nombre (L) de voies de réception dudit sous-ensemble.

**12.** Procédé d'estimation selon la revendication 11, dans lequel à l'étape de calcul est effectué en outre le calcul des valeurs transformées $(X'_1, X'_2)$ correspondant respectivement à la deuxième et à la troisième raies de fréquence de la transformation de Fourier discrète,
et dans lequel ledit estimateur est un quatrième estimateur, l'application dudit quatrième estimateur comprenant le calcul de l'argument d'un terme dépendant des valeurs transformées $(X'_1, X'_2)$ correspondant aux deuxième et troisième raies de fréquence et de valeurs de coefficients transformés.

**13.** Dispositif (30, 50, 60, 70) d'estimation d'un angle d'arrivée d'un signal radioélectrique incident par rapport à une direction de référence prédéterminée, en utilisant un ensemble de N voies de réception comportant au moins une antenne directive ($A_0$,...$A_n$, ..., $A_{N-1}$) pointant selon N directions ($\theta_0,...,\theta_n,...,\theta_{N-1}$) de réception différentes, seul un sous-ensemble d'au moins deux voies de réception à directions d'antennes adjacentes dudit ensemble de voies de réception délivrant une puissance mesurée en réception dudit signal radioélectrique incident (S), comprenant des modules (36, $38_n$, 40, 42) adaptés à :

- déterminer un nombre (L) de voies de réception délivrant une puissance mesurée formant ledit sous-ensemble, et un indice (P) de référence correspondant à une première voie de réception dans un sens de parcours de l'ensemble de directions d'antennes dudit sous-ensemble,
- sélectionner des puissances mesurées ($x_P, x_{(P+1)\mathrm{mod}N}, ..., x_{(P+L-1)\mathrm{mod}N}$) et obtenir une valeur (A) à attribuer aux puissances non mesurées pour former un signal de puissance complété ($\{x'_0, x'_1, ..., x'_{N-1}\}$) à N échantillons,
- calculer par application d'une transformation de Fourier discrète audit signal de puissance complété au moins une valeur transformée $(X'_0, X'_1, X'_2)$ parmi les valeurs transformées correspondant à une première, deuxième et troisième raies de fréquence de la transformation de Fourier discrète, la première raie de fréquence correspondant à la fréquence zéro,
- appliquer un estimateur ($\hat{\theta}$) de l'angle d'arrivée utilisant la ou les valeurs transformées calculées, ledit estimateur étant dépendant dudit indice de référence (P).

**Patentansprüche**

1. Verfahren zum Abschätzen eines Ankunftswinkels eines einfallenden Funksignals bezüglich einer vorbestimmten Referenzrichtung unter Verwendung einer Gruppe von N Empfangspfaden, welche zumindest eine Richtantenne ($A_0$,...$A_n$, ..., $A_{N-1}$) aufweisen, welche entlang N unterschiedlicher Empfangsrichtungen ($\theta_0$, ..., $\theta_n$, ...,$\theta_{N-1}$) zeigen, wobei nur eine Subgruppe von zumindest zwei Empfangspfaden mit benachbarten Antennenrichtungen der besagten Gruppe von Empfangspfaden eine gemessene Leistung beim Empfangen des besagten einfallenden Funksignals (S) liefert, die folgenden Schritte aufweisend:

   - Ermitteln von einer Anzahl (L) von Empfangspfaden, welche eine gemessene Leistung liefern, welche die besagte Subgruppe bilden, und eines Referenzindex (P), welcher zu einem ersten Empfangspfad in einer Laufrichtung der Gruppe mit Antennenrichtungen der besagten Subgruppe korrespondiert,
   - Auswählen von gemessenen Leistungen ($\chi_P,\chi_{(P+1)\mathrm{mod}N},...,\chi_{(P+L-1)\mathrm{mod}N}$) und Erlangen eines Wertes (A), welcher den nicht gemessenen Leistungen zuzuordnen ist, um ein vervollständigtes Leistungssignal $(\{\chi'_0, \chi'_1, ..., \chi'_{N-1}\})$ mit N Proben zu bilden,
   - Berechnen, mittels des Anwendens einer diskreten Fourier-Transformation auf das besagte vervollständigte Leistungssignal, von zumindest einem transformierten Wert $(X'_0, X'_1, X'_2)$ aus den transformierten Werten, welche zu einer ersten, einer zweiten und einer dritten Frequenzlinie der diskreten Fourier-Transformation korrespondieren, wobei die erste Frequenzlinie zur Frequenz null korrespondiert,
   - Anwenden einer Schätzfunktion ($\hat{\theta}$) des Ankunftswinkels unter Verwendung des oder der berechneten transformierten Werte $(X'_0, X'_1, X'_2)$, wobei die besagte Schätzfunktion vom besagten Referenzindex (P) abhängig ist.

2. Verfahren zum Abschätzen gemäß Anspruch 1, wobei der besagte Wert (A), welcher den nicht gemessenen Leistungen zuzuordnen ist, ein Wert ist, der nicht null ist, in Abhängigkeit von Indizes ($P$, ($P$+1)mod$N$,...,($P$+$L$-1)mod$N$) der Empfangskanäle der besagten Subgruppe und von den korrespondierenden gemessenen Leistungen ($\chi_P,\chi_{(P+1)\mathrm{mod}N},...,\chi_{(P+L-1)\mathrm{mod}N}$).

3. Verfahren zum Abschätzen gemäß Anspruch 2, wobei der besagte Wert (A), welcher den nicht gemessenen Leistungen zuzuordnen ist, ferner von einer gemessenen Frequenz ($\hat{f}$) des Funksignals abhängt.

4. Verfahren zum Abschätzen gemäß Anspruch 2 oder 3, wobei der besagte Wert (A), welcher den nicht gemessenen Leistungen zuzuordnen ist, im Wesentlichen gleich ist zu einem mittleren Wert von N Leistungen, welche ausgehend von einem Strahlungsdiagramm erlangt werden, welches zur Leistung korrespondiert, welche mittels einer Empfangspfad-Antenne gemessen wird.

5. Verfahren zum Abschätzen gemäß den Ansprüchen 2 bis 4, wobei eine Mehrzahl von Werten (A), welche den nicht gemessenen Leistungen zuzuordnen sind, vorab erlangt werden mittels Berechnens oder mittels Experimentierens, wobei die besagten Werte in einer Tabelle (32) gespeichert werden.

6. Verfahren zum Abschätzen gemäß einem der Ansprüche 2 bis 5, wobei im Schritt des Berechnens das Berechnen des transformierten Wertes $(X'_1)$, welcher zur zweiten Frequenzlinie der diskreten Fourier-Transformation korrespondiert, durchgeführt wird, wobei der besagte transformierte Wert eine komplexe Zahl ist, welche mittels eines Moduls und eines Arguments definiert ist.

7. Verfahren zum Abschätzen gemäß Anspruch 6, wobei die besagte Schätzfunktion eine erste Schätzfunktion ist, wobei das Anwenden der besagten ersten Schätzfunktion aufweist das Berechnen des Arguments des berechneten transformierten Werts und das Subtrahieren des besagten Arguments von einem Referenzwinkel-Wert ($\theta_0$).

8. Verfahren zum Abschätzen gemäß Anspruch 6, wobei das Anwenden einer Schätzfunktion mindestens einen Wert

($C_k(P,L)$) eines transformierten Koeffizienten verwendet, welcher erlangt wird mittels Anwendens der Fourier-Transformation auf eine Gruppe von Koeffizienten, welche repräsentativ sind für die Subgruppe von Antennenrichtungen, welche eine gemessene Leistung bereitstellt,
wobei der besagte Wert eines transformierten Koeffizienten abhängig ist vom Referenzindex (P) und von der Anzahl (L) an Empfangspfaden der besagten Subgruppe.

**9.** Verfahren zum Abschätzen gemäß Anspruch 8, wobei im Schritt des Berechnens ferner das Berechnen des transformierten Werts $(X'_0)$ durchgeführt wird, welcher zur ersten Frequenzlinie der diskreten Fourier-Transformation korrespondiert,
und wobei die besagte Schätzfunktion eine zweite Schätzfunktion ist, wobei das Anwenden der besagten zweiten Schätzfunktion aufweist das Berechnen des Arguments eines Terms, welcher abhängig ist von den transformierten Werten, welche zur ersten und zur zweiten Frequenzlinie korrespondieren, vom besagten Wert, welcher den nicht gemessenen Leistungen zuzuordnen ist, und von Werten von transformierten Koeffizienten.

**10.** Verfahren zum Abschätzen gemäß Anspruch 8, wobei im Schritt des Berechnens ferner das Berechnen der transformierten Werte $(X'_0, X'_2)$ durchgeführt wird, welche jeweilig zur ersten und zur dritten Frequenzlinie der diskreten Fourier-Transformation korrespondieren,
und wobei die besagte Schätzfunktion eine dritte Schätzfunktion ist, wobei das Anwenden der besagten dritten Schätzfunktion aufweist das Berechnen des Arguments eines Terms, welcher abhängig ist von den transformierten Werten $(X'_0, X'_1, X'_2),$ welche zur ersten, zur zweiten und zur dritten Frequenzlinie korrespondieren, vom besagten Wert, welcher den nicht gemessenen Leistungen zugeordnet ist, und von Werten von transformierten Koeffizienten.

**11.** Verfahren zum Abschätzen gemäß Anspruch 1, wobei der besagte Wert, welcher den nicht gemessenen Leistungen zuzuordnen ist, gleich null ist, und wobei das Anwenden einer Schätzfunktion mindestens einen Wert eines transformierten Koeffizienten ($C_k(P,L)$) verwendet, welcher erlangt wird mittels des Anwendens der Fourier-Transformation auf eine Gruppe von Koeffizienten, welche repräsentativ ist für die Subgruppe von Antennenrichtungen, welche eine gemessene Leistung bereitstellt, wobei der besagte Wert eines transformierten Koeffizienten abhängig ist vom Referenzindex (P) und von der Anzahl (L) an Empfangspfaden der besagten Subgruppe.

**12.** Verfahren zum Abschätzen gemäß Anspruch 11, wobei im Schritt des Berechnens ferner das Berechnen der transformierten Werte $(X'_1, X'_2)$ durchgeführt wird, welche jeweilig zur zweiten und zur dritten Frequenzlinie der diskreten Fourier-Transformation korrespondieren,
und wobei die besagte Schätzfunktion eine vierte Schätzfunktion ist, wobei das Anwenden der vierten Schätzfunktion aufweist das Berechnen des Arguments eines Terms, welcher abhängig ist von den transformierten Werten $(X'_1, X'_2),$ welche zur zweiten und zur dritten Frequenzlinie korrespondieren, und von Werten von transformierten Koeffizienten.

**13.** Vorrichtung (30, 50, 60, 70) zum Abschätzen eines Ankunftswinkels eines einfallenden Funksignals bezüglich einer vorbestimmten Referenzrichtung unter Verwendung von einer Gruppe von N Empfangspfaden, welche zumindest eine Richtantenne ($A_0$,..., $A_n$,..., $A_{N-1}$) aufweisen, welche entlang N unterschiedlicher Empfangsrichtungen ($\theta_0$, ..., $\theta_n$, ..., $\theta_{N-1}$) zeigen, wobei nur eine Subgruppe von zumindest zwei Empfangspfaden mit benachbarten Antennenrichtungen der besagten Gruppe von Empfangspfaden beim Empfangen des besagten einfallenden Funksignals (S) eine gemessene Leistung liefert, aufweisend Module (36, $38_n$, 40, 42), welche angepasst sind, um:

- eine Anzahl (L) von Empfangspfaden, welche eine gemessene Leistung liefern, welche die besagte Subgruppe bilden, und einen Referenzindex (P), welcher zu einem ersten Empfangspfad in einer Laufrichtung der Gruppe mit Antennenrichtungen der besagten Subgruppe korrespondiert, zu ermitteln,
- gemessene Leistungen ($\chi_P, \chi_{(P+1)\mathrm{mod}N}, \ldots, \chi_{(P+L-1)\mathrm{mod}N}$) auszuwählen und einen Wert (A) zu erlangen, welcher den nicht gemessenen Leistungen zuzuordnen ist, um ein vervollständigtes Leistungssignal $(\{\chi'_0, \chi'_1, \ldots, \chi'_{N-1}\})$ mit N Proben zu bilden,

- mittels des Anwendens einer diskreten Fourier-Transformation auf das besagte vervollständigte Leistungssignal zumindest einen transformierten Wert $(X'_0, X'_1, X'_2)$ aus den transformierten Werten, welche zu einer ersten, einer zweiten und einer dritten Frequenzlinie der diskreten Fourier-Transformation korrespondieren, zu berechnen, wobei die erste Frequenzlinie zur Frequenz null korrespondiert,
- eine Schätzfunktion ($\hat{\theta}$) des Ankunftswinkels unter Verwendung des oder der berechneten transformierten Werte anzuwenden, wobei die besagte Schätzfunktion vom besagten Referenzindex (P) abhängig ist.

## Claims

1. An angle estimation method for estimating an angle of arrival of an incident radio signal in relation to a predetermined reference direction, by using a set of N receiving paths comprising at least one directional antenna ($A_0$,... $A_n$, ..., $A_{N-1}$) pointing in N different receiving directions ($\theta_0,...,\theta_n,..., \theta_{N-1}$),wherein only a sub-set of at least two receiving paths with adjacent antenna directions in the said set of receiving paths delivers a measured power at reception of the said incident radio signal (S), comprising steps of :

   - determination of a number (L) of receiving paths delivering a measured power forming the said sub-set, and a reference index (P) corresponding to a first receiving path in a direction in which extends the set of antenna directions of the said sub-set;
   - selection of the measured powers ($x_P, x_{(P+1)\text{mod}N},...,x_{(P+L-1)\text{mod}N}$) and obtaining of a value (A) to be attributed to the non-measured powers to form a completed power signal ( $\{x'_0, x'_1,...,x'_{N-1}\}$) with N samples;
   - calculation, by applying a discrete Fourier transform to the said completed power signal, of at least one transformed value $(X'_0, X'_1, X'_2)$ from among the transformed values corresponding to a first, second, and third frequency line of the discrete Fourier transform, the first frequency line corresponding to the zero frequency;
   - application of an estimator ($\hat{\theta}$) of the angle of arrival using the calculated transformed value or values $(X'_0, X'_1, X'_2)$ the said estimator being dependent on the said reference index (P).

2. An angle estimation method according to claim 1, wherein the said value (A) to be attributed to the non-measured powers is a non-zero value, depending on the indices ( $P$, $(P + 1) \bmod N$,...,$(P + L - 1) \bmod N$) of the receiving paths of the said sub-set and the corresponding measured powers ($x_P, x_{(P+1)\text{mod}N},...,x_{(P+L-1)\text{mod}N}$).

3. An angle estimation method according to claim 2, wherein the said value (A) to be attributed to the non-measured powers further depends on a measured frequency ($\hat{f}$) of the radio signal.

4. An angle estimation method according to claim 2 or 3, wherein the said value (A) to be attributed to the non-measured powers is substantially equal to an average value of N powers obtained from at least one radiation pattern corresponding to the power measured by a receiving path antenna.

5. An angle estimation method according to claims 2 to 4, wherein a plurality of values (A) to be attributed to the non-measured powers is obtained in advance by calculation or by experimentation, the said values being stored in a table (32).

6. An angle estimation method according to one of claims 2 to 5, wherein in the calculation step, the calculation is performed of the transformed value $(X'_1)$ corresponding to the second frequency line of the discrete Fourier transform, the said transformed value being a complex number defined by a modulus and an argument.

7. An angle estimation method according to claim 6, wherein the said estimator is a first estimator, the application of the said first estimator comprising the calculation of the argument of the calculated transformed value and subtraction of the said argument from a reference angle value ($\theta_0$).

8. An angle estimation method according to claim 6, wherein the applying of an estimator makes use of at least one value ($C_k(P,L)$) of transformed coefficient obtained by applying the Fourier transform to a set of coefficients representative of the sub-set of antenna directions delivering a measured power,

the said value of transformed coefficient depending on the reference index (P) and the number (L) of receiving paths of the said sub-set.

**9.** An angle estimation method according to claim 8, wherein in the calculation step additionally the calculation is also performed, of the transformed value $(X'_0)$ corresponding to the first frequency line of the discrete Fourier transform, and wherein the said estimator is a second estimator, the application of the said second estimator comprising the calculation of the argument of a term that is dependent on the transformed values corresponding to the first and to the second frequency lines, on the said value to be attributed to the non-measured powers and on values of transformed coefficients.

**10.** An angle estimation method according to claim 8, wherein in the calculation step additionally the calculation is also performed, of the transformed values $(X'_0, X'_2)$ corresponding respectively to the first and to the third frequency lines of the discrete Fourier transform,
and wherein the said estimator is a third estimator, the application of the said third estimator comprising the calculation of the argument of a term that is dependent on the transformed values $(X'_0, X'_1, X'_2)$ corresponding to the first, second, and third frequency lines, on the said value attributed to the non-measured powers and on values of transformed coefficients.

**11.** An angle estimation method according to claim 1, wherein the said value to be attributed to the non-measured powers is equal to zero, and wherein the applying of an estimator makes use of at least one value of transformed coefficient ($C_k(P,L)$) obtained by applying the Fourier transform to a set of coefficients representative of the sub-set of antenna directions delivering a measured power, the said value of transformed coefficient depending on the reference index (P) and on the number (L) of receiving paths of the said sub-set.

**12.** An angle estimation method according to claim 11, wherein in the calculation step, additionally the calculation is also performed, of the transformed values $(X'_1, X'_2)$ corresponding respectively to the second, and to the third frequency lines of the discrete Fourier transform,
and wherein the said estimator is a fourth estimator, the application of the said fourth estimator comprising the calculation of the argument of a term that is dependent on the transformed values $(X'_1, X'_2)$ corresponding to the second, and third frequency lines and on values of transformed coefficients.

**13.** An angle estimation device (30, 50, 60, 70) for estimating an angle of arrival of an incident radio signal in relation to a predetermined reference direction, by using a set of N receiving paths comprising at least one directional antenna ($A_0$, ... $A_n$, ..., $A_{N-1}$) pointing in N different receiving directions ($\theta_0,...,\theta_n,...,\theta_{N-1}$), wherein only a sub-set of at least two receiving paths with adjacent antenna directions in the said set of receiving paths delivers a measured power at reception of the said incident radio signal (S), comprising suitable modules (36, $38_n$, 40, 42) that are capable of:

- determining a number (L) of receiving paths delivering a measured power forming the said sub-set, and a reference index (P) corresponding to a first receiving path in a direction in which extends the set of antenna directions of the said sub-set,
- selecting the measured powers ($x_P, x_{(P+1)\mathrm{mod}N},...,x_{(P+L-1)\mathrm{mod}N}$) and obtaining a value (A) to be attributed to the non-measured powers to form a completed power signal ( $\{x'_0,x'_1,...,x'_{N-1}\}$) with N samples,
- calculating, by applying a discrete Fourier transform to the said completed power signal, at least one transformed value $(X'_0, X'_1, X'_2)$ from among the transformed values corresponding to a first, second, and third frequency line of the discrete Fourier transform, the first frequency line corresponding to the zero frequency,
- applying an estimator ($\hat{\theta}$) of the angle of arrival using the calculated transformed value or values, the said estimator being dependent on the said reference index (P).

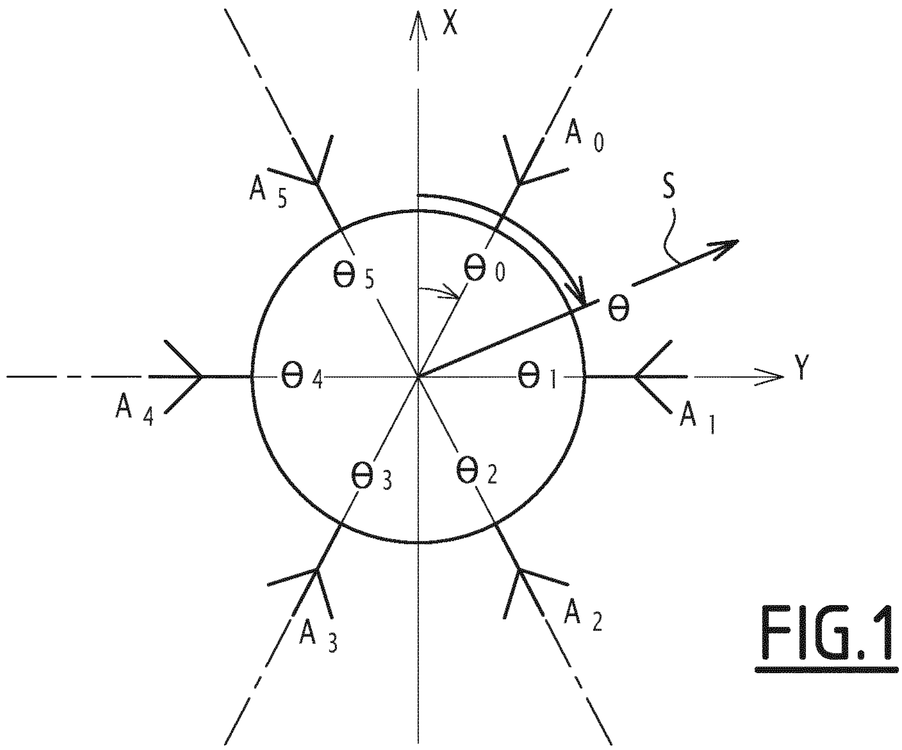
X
Y
S
A 0
A 1
A 2
A 3
A 4
A 5
Θ 0
Θ 1
Θ 2
Θ 3
Θ 4
Θ 5
Θ

FIG.1

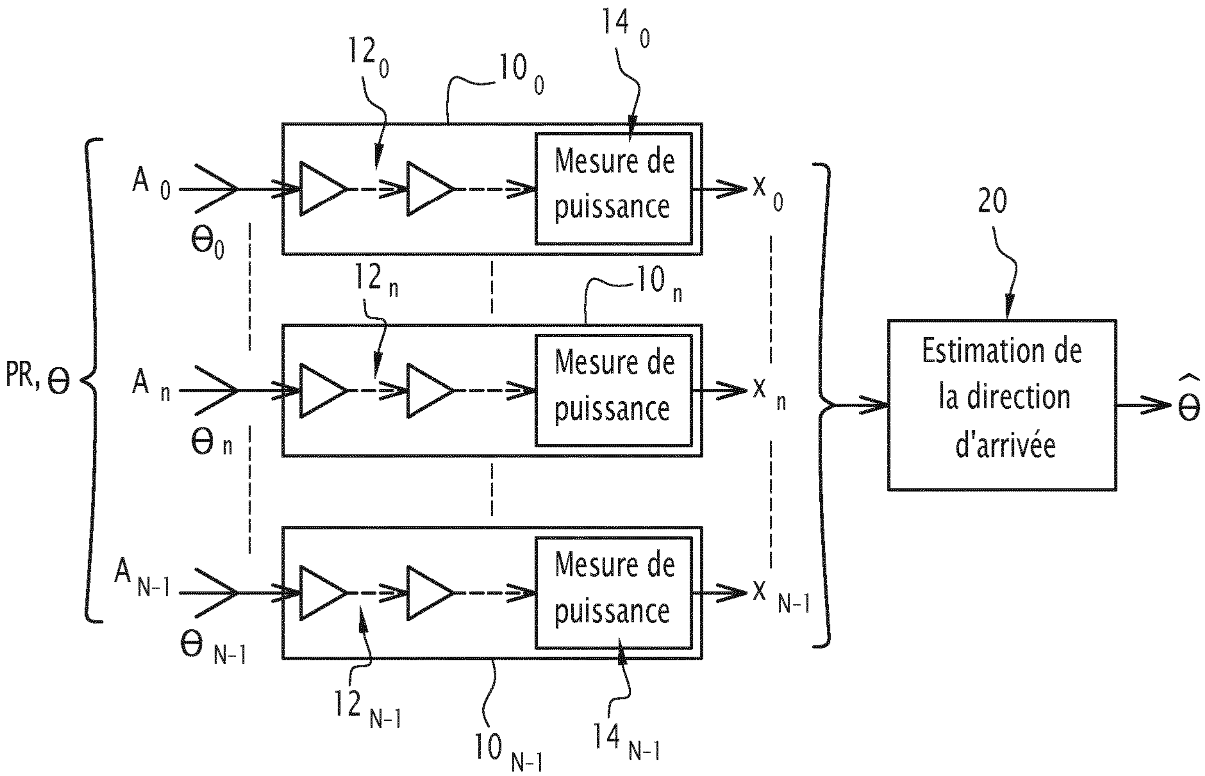
14 0
12 0
10 0
A 0
Θ0
Mesure de puissance
x 0
12 n
10 n
PR, Θ
A n
Θ n
Mesure de puissance
x n
A N-1
Θ N-1
Mesure de puissance
x N-1
12 N-1
10 N-1
14 N-1
20
Estimation de la direction d'arrivée
Θ̂

FIG.2

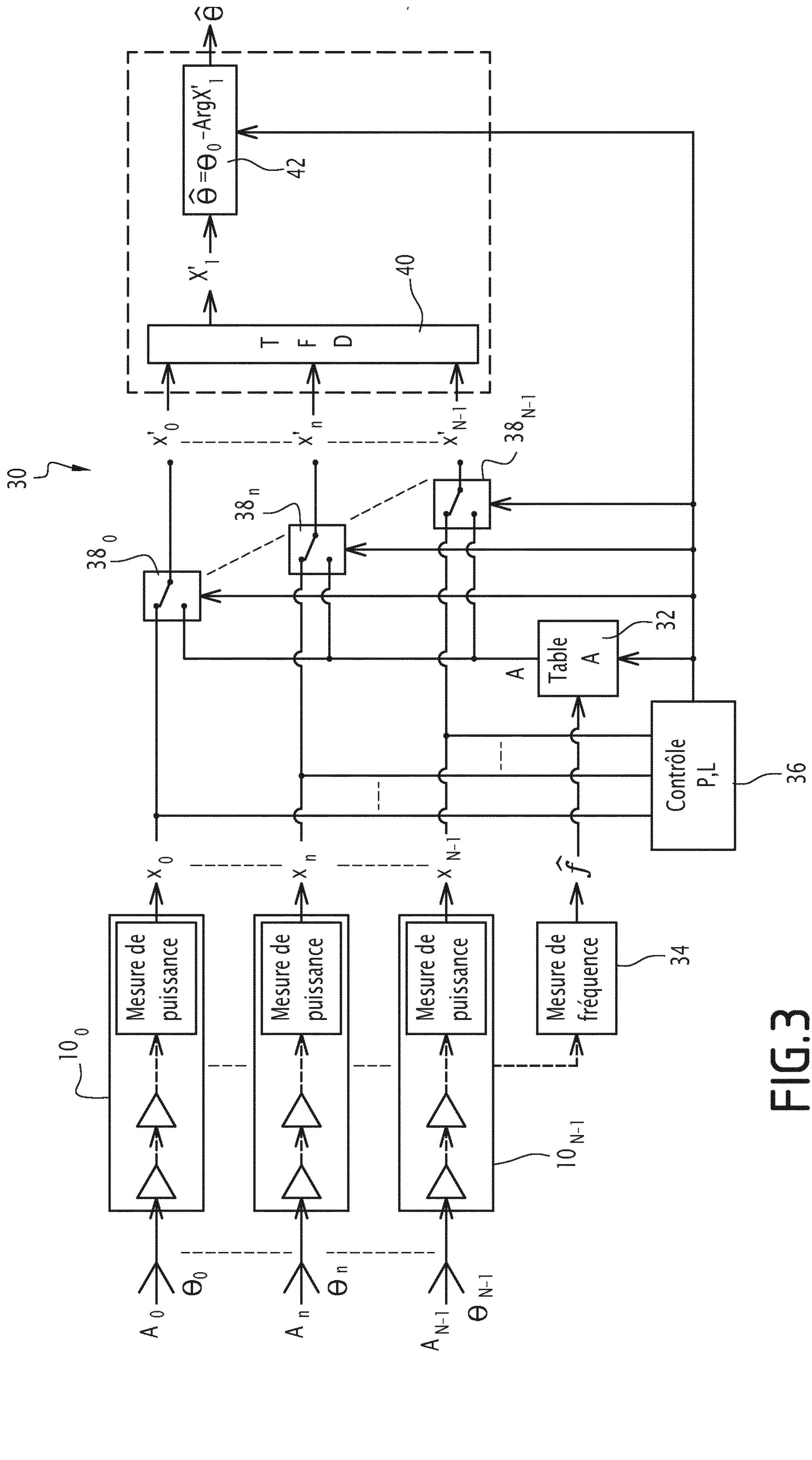

30
$A_0$
$\theta_0$
$A_n$
$\theta_n$
$A_{N-1}$
$\theta_{N-1}$
$10_0$
$10_{N-1}$
Mesure de puissance
Mesure de puissance
Mesure de puissance
Mesure de fréquence
34
$x_0$
$x_n$
$x_{N-1}$
$\hat{f}$
Contrôle P,L
36
A
Table A
32
$38_0$
$38_n$
$38_{N-1}$
$x'_0$
$x'_n$
$x'_{N-1}$
T F D
40
$X'_1$
$\hat{\theta}=\theta_0-ArgX'_1$
42
$\hat{\theta}$


FIG.3

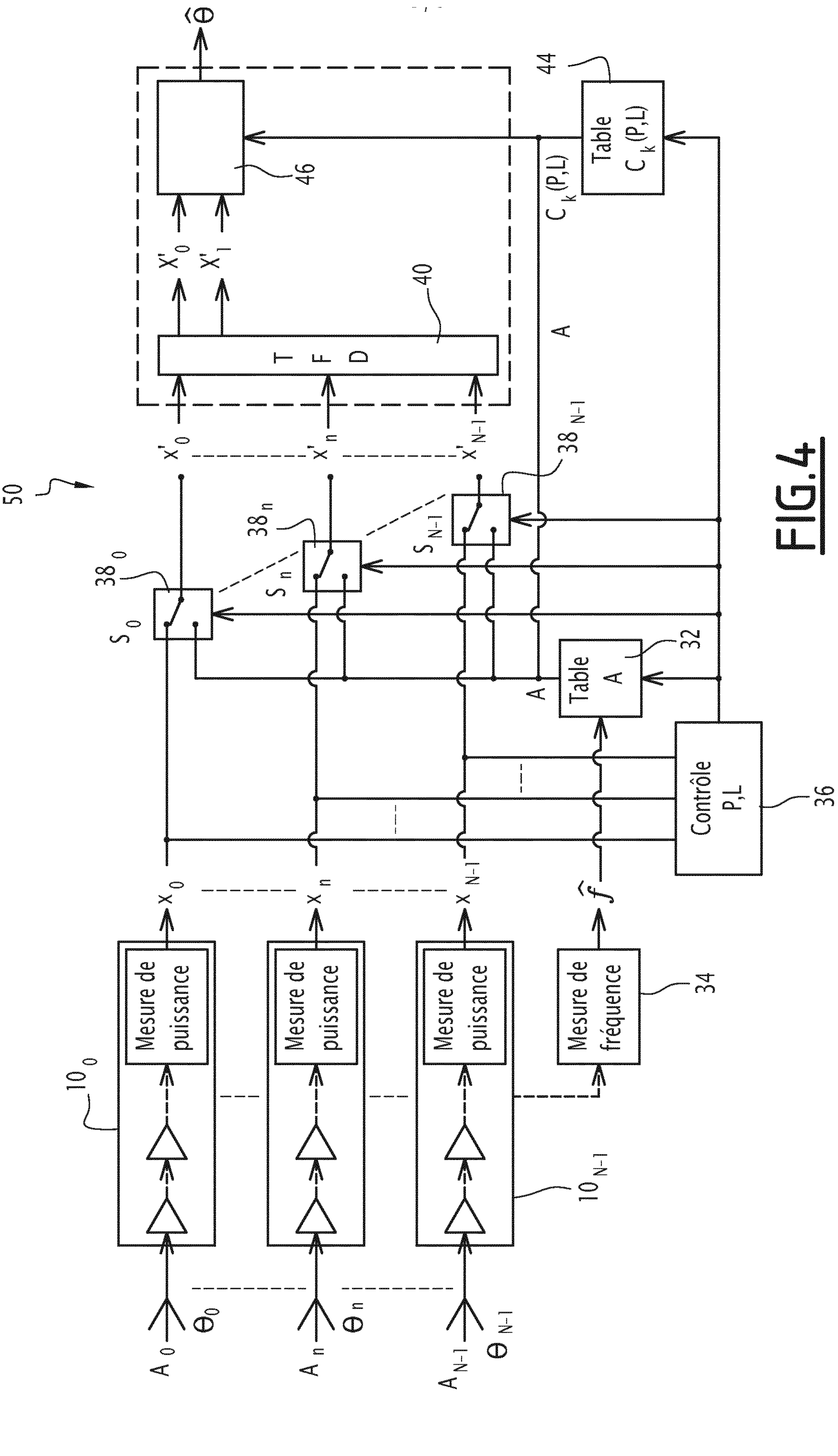
Mesure de puissance
Mesure de puissance
Mesure de puissance
Mesure de fréquence
Contrôle P,L
Table A
Table $C_k(P,L)$
T F D
$C_k(P,L)$
A
A
$A_0$
$A_n$
$A_{N-1}$
$\theta_0$
$\theta_n$
$\theta_{N-1}$
$x_0$
$x_n$
$x_{N-1}$
$\hat{f}$
$S_0$
$S_n$
$S_{N-1}$
$x'_0$
$x'_n$
$x'_{N-1}$
$X'_0$
$X'_1$
$\hat{\theta}$
$10_0$
$10_{N-1}$
$38_0$
$38_n$
$38_{N-1}$
32
34
36
40
44
46
50

FIG.4

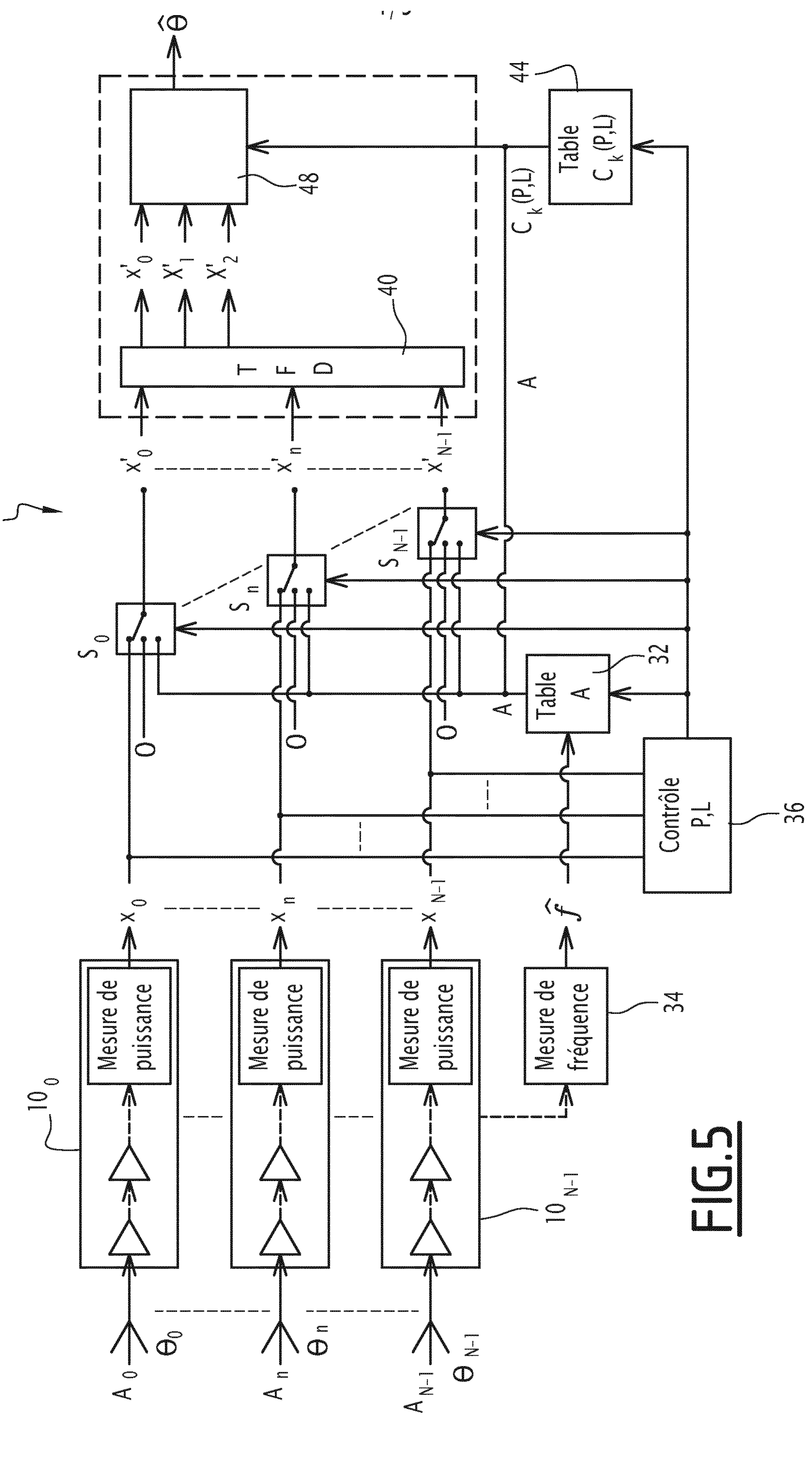
Mesure de puissance
Mesure de puissance
Mesure de puissance
Mesure de fréquence
Contrôle P,L
Table A
Table $C_k(P,L)$
T F D
$x_0$
$x_n$
$x_{N-1}$
$\hat{f}$
$x'_0$
$x'_n$
$x'_{N-1}$
$X'_0$
$X'_1$
$X'_2$
$\hat{\theta}$
$S_0$
$S_n$
$S_{N-1}$
$A_0$
$A_n$
$A_{N-1}$
$\theta_0$
$\theta_n$
$\theta_{N-1}$
$10_0$
$10_{N-1}$
$C_k(P,L)$
A
0
32
34
36
40
44
48
60

FIG.5

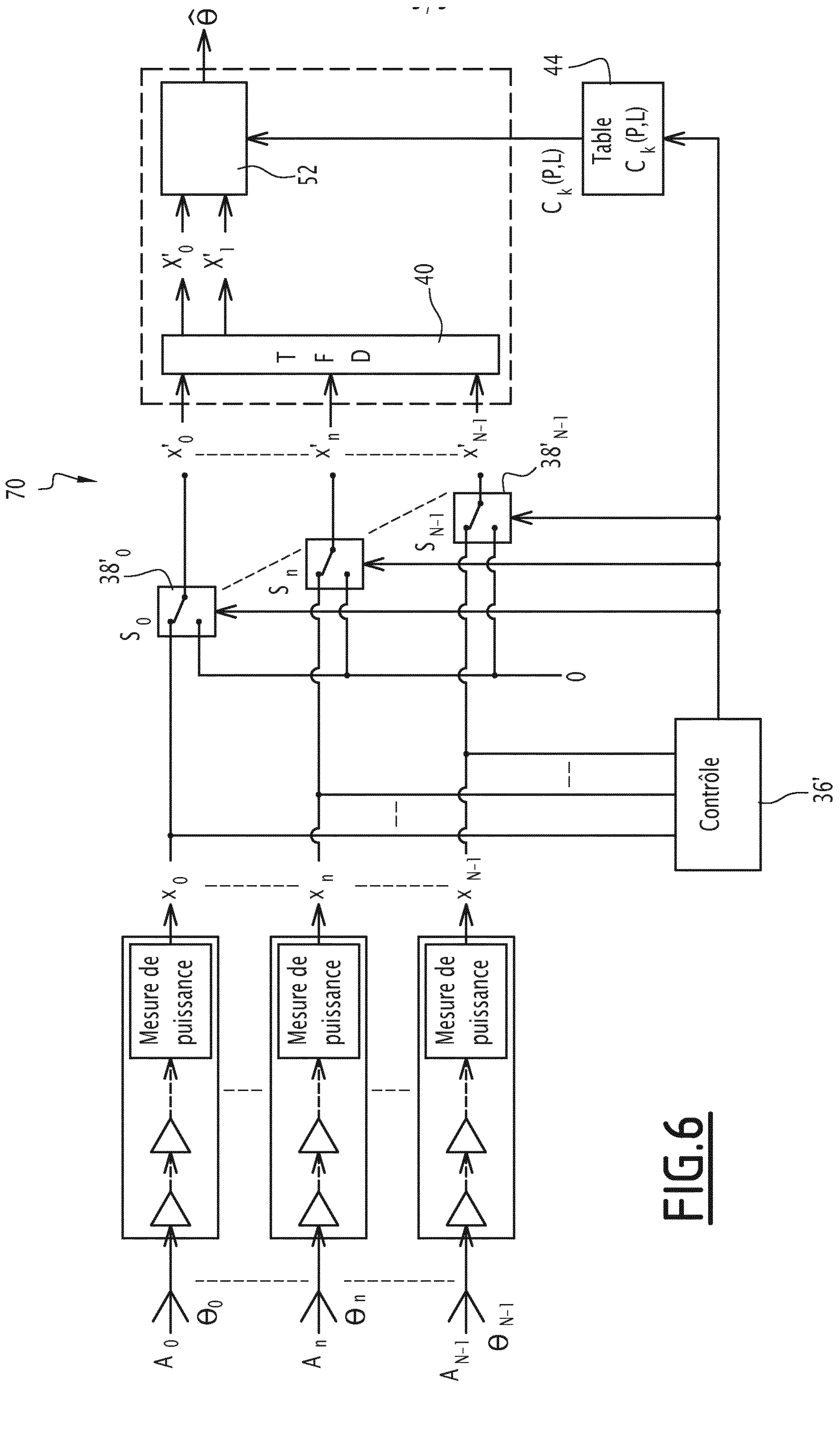
70
Mesure de puissance
Mesure de puissance
Mesure de puissance
Contrôle
36'
TFD
40
52
Table $C_k(P,L)$
44
$C_k(P,L)$
0

FIG.6

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

### Documents brevets cités dans la description


- WO 2007028278 A1
- US 2014159954 A1


### Littérature non-brevet citée dans la description


- **LIE et al.** Single antenna power measurements based direction finding with incomplète spatial coverage. *ICASSP,* 2012